# EUROPÄISCHE PATENTSCHRIFT

(11) **EP 3 914 918 B1**
(45) Veröffentlichungstag und Bekanntmachung des Hinweises auf die Patenterteilung: **06.03.2024**
(21) Anmeldenummer: 20700706.3
(22) Anmeldetag: 13.01.2020
(51) Int. Cl.: G01R 31/12, H02H 3/04

(54) **ÜBERPRÜFEN VON MANTELSPANNUNGSBEGRENZERN**
INSPECTING SHEATH VOLTAGE LIMITERS
TEST DE LIMITEURS DE TENSION DE GAINE

(30) Priorität: 23.01.2019 AT 500492019
(43) Veröffentlichungstag der Anmeldung: 01.12.2021
(73) Patentinhaber: Omicron Energy Solutions GmbH, 12099 Berlin (DE)
(72) Erfinder: EMANUEL, Harald, 10179 Berlin (DE); COBET, Andreas, 12203 Berlin (DE); SCHLEIFER, Hendrik, 10115 Berlin (DE)
(74) Vertreter: Kraus & Lederer PartGmbB
(86) Internationale Anmeldenummer: PCT/EP2020/050718
(87) Internationale Veröffentlichungsnummer: WO 2020/151986

(56) Entgegenhaltungen:
- EP-A1- 2 392 934
- DE-A1- 19 629 481

## Beschreibung

### GEBIET DER ERFINDUNG

Die vorliegende Erfindung betrifft ein Verfahren zum Überprüfen von mehreren Mantelspannungsbegrenzern für mehrere Hochspannungskabel eines mehrphasigen Hochspannungskabelsystems. Die Erfindung betrifft weiterhin eine Vorrichtung, welche für eine Durchführung des Verfahrens zum Überprüfen von mehreren Mantelspannungsbegrenzern ausgestaltet ist.

### HINTERGRUND DER ERFINDUNG

Ein Hochspannungskabel ist ein elektrisches Kabel, welches für den Betrieb mit Hochspannung, beispielsweise einer Spannung in der Größenordnung von bis zu 500 kV, ausgelegt ist. Ein Hochspannungskabel kann beispielsweise zur Übertragung von großen Leistungen, beispielsweise mehrere 100 MW und darüber hinaus, in Stromnetzen zur elektrischen Energieversorgung verwendet werden. Ein Hochspannungskabel kann am Boden, im Erdreich oder als Seekabel unter Wasser verwendet werden.

Die Energieübertragung in Stromnetzen erfolgt üblicherweise mehrphasig, insbesondere dreiphasig. Für den in elektrischen Energienetzen üblichen Dreiphasenwechselstrom sind drei einzelne, parallel verlegte Hochspannungskabel erforderlich. Hochspannungskabel umfassen, wie andere Kabel auch, eine isolierende Ummantelung um den spannungsführenden elektrischen Leiter. Durch die hohen Spannungen ist das Isolationsmaterial dicker ausgeführt, um den hohen elektrischen Feldstärken zu widerstehen, und das Hochspannungskabel umfasst eine äußere Abschirmung, welche den elektrischen Feldstärkeverlauf im Isolationsmaterial festlegt. Üblicherweise ist ein Hochspannungskabel im Querschnitt axial symmetrisch aufgebaut mit einem elektrischen Leiter im Zentrum, einem Isolationsmaterial um den elektrischen Leiter herum und der äußeren elektrischen Abschirmung sowie einer Außenisolierung, welche das Hochspannungskabel vor Umwelteinflüssen, Feuchtigkeit und mechanischen Schäden schützt.

Aus logistischen Gründen hat ein isoliertes Hochspannungskabel nach der Herstellung eine Länge von 800-1000 m. Da im Allgemeinen größere Strecken überbrückt werden sollen, werden die hergestellten Kabelsegmente miteinander verbunden. Diese Verbindungen werden auch "Joints" genannt. Da in diese Joints eindringendes Wasser zu Problemen führen kann, beispielsweise abfließende Ströme, Teilentladungen oder Kurzschlüsse, können diese Joints in einem Kasten gelagert werden, welcher mit einem wasserabweisenden Gel gefüllt ist. Andere Schutzmechanismen, beispielsweise gegen Wassereintritt gut geschützte Kästen, können ebenso verwendet werden.

Wie zuvor beschrieben, umfassen die Hochspannungskabel neben dem inneren elektrischen Leiter auch einen äußeren Schirm, in welchem durch Induktion oder andere Effekte Potenziale gegenüber der Erde (Masse) entstehen können. Damit diese Potenziale so gering wie möglich sind, werden die Schirme bei den Joints zwischen den drei Phasen ausgekreuzt und beispielsweise bei jedem dritten Joint geerdet. Bei der Erdung können große elektrische Ströme auftreten, welche zu begrenzen sind. Hierfür können sogenannte Mantelspannungsbegrenzer (englisch: Sheath Voltage Limiter, SVL) verwendet werden, welche sich ebenfalls in dem Kasten des Joints befinden.

Durch Spannungsspitzen können die Mantelspannungsbegrenzer (SVL) beschädigt werden und sind daher regelmäßig, beispielsweise jährlich, vorzugsweise jedoch öfter, auf ihre Funktionsfähigkeit zu prüfen. Zwei Arten von Defekten sind bei den Mantelspannungsbegrenzern möglich: der Mantelspannungsbegrenzer wirkt wie ein Kurzschluss, sodass die Funktion der Strombegrenzung aufgehoben ist, oder der Mantelspannungsbegrenzer weist einen sehr hohen (unendlichen) Widerstand auf und kann daher die Potenziale gegenüber Erde nicht mehr ableiten.

Für die Überprüfung der Funktion der Mantelspannungsbegrenzer wird die Nutzung des Hochspannungskabels üblicherweise temporär beendet. Die Mantelspannungsbegrenzer werden freigelegt, beispielsweise indem der Kasten, welcher den Joint enthält, geöffnet wird und gegebenenfalls das darin befindliche Gel abgepumpt wird. Jeder einzelne Mantelspannungsbegrenzer wird ausgebaut und durchgemessen. Insbesondere bei langen Kabelstrecken ist diese Vorgehensweise sehr aufwendig und wird daher nur selten, beispielsweise jährlich, durchgeführt. Dadurch können fehlerhafte Mantelspannungsbegrenzer lange Zeit unerkannt bleiben, wodurch Folgeschäden an dem elektrischen Energieübertragungssystem auftreten können. Darüber hinaus ist während der Überprüfung der Mantelspannungsbegrenzer das Hochspannungskabel nicht verwendbar, wodurch Ersatzschaltungen erforderlich sein können und zusätzliche Kosten entstehen können.

Die Dokumente EP2392934A1 und DE19629481 A1 offenbaren jeweils eine Prüfung eines Kabelsystems.

### ZUSAMMENFASSUNG DER ERFINDUNG

Aufgabe der vorliegenden Erfindung ist es daher, das Überprüfen von Mantelspannungsbegrenzern zu vereinfachen und eine zuverlässigere Bestimmung von fehlerhaften Mantelspannungsbegrenzern zu ermöglichen.

Diese Aufgabe wird gemäß der vorliegenden Erfindung durch ein Verfahren zum Überprüfen von mehreren Mantelspannungsbegrenzern für mehrere Hochspannungskabel eines mehrphasigen Hochspannungskabelsystems nach Anspruch 1 sowie eine Vorrichtung zum Überprüfen von mehreren Mantelspannungsbegrenzern für mehrere Hochspannungskabel eines mehrphasigen Hochspannungskabelsystems nach Anspruch 13 gelöst. Die abhängigen Ansprüche definieren Ausführungsformen der Erfindung.

Gemäß der vorliegenden Erfindung wird ein Verfahren zum Überprüfen von mindestens einem Mantelspannungsbegrenzer für mindestens ein Hochspannungskabel eines Hochspannungskabelsystems bereitgestellt. Beispielsweise können mehrere Mantelspannungsbegrenzer für mehrere Hochspannungskabel eines mehrphasigen Hochspannungskabelsystems überprüft werden. Der eine oder die mehreren Mantelspannungsbegrenzer können beispielsweise in einem Kasten einer Verbindung (Joint) zwischen zwei Kabelsegmenten angeordnet sein. Ein jeweiliger Mantelspannungsbegrenzer der mehreren Mantelspannungsbegrenzer ist zwischen einen Kabelschirm eines jeweiligen Hochspannungskabels der mehreren Hochspannungskabel und einen gemeinsamen Erdungsanschluss geschaltet. Anders ausgedrückt wird über jeweils einen Mantelspannungsbegrenzer ein Kabelschirm eines jeweiligen Hochspannungskabels mit dem gemeinsamen Erdungsanschluss verbunden. Das Hochspannungskabelsystem kann beispielsweise drei Hochspannungskabel zur Übertragung eines dreiphasigen Hochspannungswechselstroms umfassen. Bei dem Verfahren wird ein elektrisches Prüfsignal an dem gemeinsamen Erdungsanschluss eingespeist. Weiterhin werden ein oder mehrere elektrische Messsignale erfasst, wobei ein jeweiliges elektrisches Messsignal der mehreren elektrischen Messsignale an dem Kabelschirm eines jeweiligen Hochspannungskabels der mehreren Hochspannungskabel erfasst wird. Eine Funktionsfähigkeit des einen oder der mehreren Mantelspannungsbegrenzer wird in Abhängigkeit von den erfassten elektrischen Messsignalen bestimmt. Anders ausgedrückt wird das elektrische Prüfsignal an dem gemeinsamen Erdungsanschluss eingespeist und somit über den oder die Mantelspannungsbegrenzer in die Kabelschirme der Hochspannungskabel eingespeist. An jedem Kabelschirm der Hochspannungskabel wird ein jeweiliges elektrisches Messsignal erfasst und aus den erfassten elektrischen Messsignalen die Funktionsfähigkeit der Mantelspannungsbegrenzer ermittelt. Das Verfahren kann sowohl in Verbindung mit einem einphasigen Hochspannungskabelsystem mit nur einem Mantelspannungsbegrenzer in einem Joint als auch in Verbindung mit einem mehrphasigen Hochspannungskabelsystem mit jeweils einem Mantelspannungsbegrenzer pro Phase in einem Joint verwendet werden. Es ist zu beachten, dass insbesondere bei der Verwendung des Verfahrens in Verbindung mit einem mehrphasigen Hochspannungskabelsystem das elektrische Prüfsignal über den gemeinsamen Erdungsanschluss gleichzeitig in die mehreren Mantelspannungsbegrenzer eingespeist wird und entsprechende Antwortsignale an den Kabelschirmen der mehreren Hochspannungssignal als die mehreren elektrischen Messsignale erfasst werden, um auf der Grundlage dieser mehreren elektrischen Messsignale die Funktionsfähigkeit der mehreren Mantelspannungsbegrenzer zu bestimmen.

Das elektrische Prüfsignal kann beispielsweise induktiv eingespeist werden. Das elektrische Prüfsignal kann beispielsweise mittels eines Hochfrequenzstromtransformators eingespeist werden, welcher um ein Kabel gelegt wird, welches die mehreren Mantelspannungsbegrenzer mit dem gemeinsamen Erdungsanschluss verbindet. Derartige Hochfrequenzstromtransformatoren sind im Fachgebiet der Energietechnik bekannt und werden beispielsweise zur Detektion von Teilentladungen in Hochspannungskabeln verwendet.

Die mehreren elektrischen Messsignale können ebenfalls induktiv erfasst werden, beispielsweise mittels Hochfrequenzstromtransformatoren. Beispielsweise kann um den Mantel eines jeden Hochspannungskabels ein entsprechender Hochfrequenzstromtransformators angeordnet werden, um die elektrischen Messsignale an dem Kabelschirm des jeweiligen Hochspannungskabels zu erfassen. Wiederum sind derartige Hochfrequenzstromtransformatoren in der Energietechnik bekannt, beispielsweise zur Detektion von Teilentladungen in Hochspannungskabeln.

Insbesondere die induktive Erfassung der elektrischen Messsignale und die induktive Einspeisung des elektrischen Prüfsignals ermöglicht, dass das Einspeisen des elektrischen Prüfsignals und das Erfassen der mehreren elektrischen Messsignale im Betrieb des mehrphasigen Hochspannungskabelsystems durchgeführt werden kann. Anders ausgedrückt kann das elektrische Prüfsignal eingespeist werden und die mehreren elektrischen Messsignale können erfasst werden, während an den mehreren Hochspannungskabeln des mehrphasigen Hochspannungskabelsystems eine Hochspannung anliegt und Energie übertragen wird.

Weiterhin können beispielsweise mittels der Hochfrequenzstromtransformatoren, welche an den Hochspannungskabeln angeordnet sind, Teilentladungen zwischen einem Innenleiter und einem Kabelschirm von mindestens einem Hochspannungskabel der mehreren Hochspannungskabel in Abhängigkeit von den erfassten Messsignalen bestimmt werden. Somit können im Betrieb des Hochspannungskabelsystems nicht nur die Mantelspannungsbegrenzer überprüft werden, sondern auch die Funktionsfähigkeit der einzelnen Hochspannungskabel, insbesondere deren Isolation zwischen dem Innenleiter und dem Kabelschirm.

Gemäß einer Ausführungsform ist das Prüfsignal ein breitbandiges Prüfsignal mit einem Frequenzbereich von zumindest 500 kHz bis 8 MHz. Die Kabelschirme können entlang der gesamten Länge des Hochspannungskabelsystems ausgekreuzt sein, beispielsweise an den Joints. Ferner können weitere Mantelspannungsbegrenzer entlang der gesamten Länge des Hochspannungskabelsystems angeordnet sein, beispielsweise an den Joints. Da die Kabelschirme an den Joints ausgekreuzt sein können und Mantelspannungsbegrenzer an mehreren Joints entlang der gesamten Länge des Hochspannungskabelsystems angeordnet sein können, kann ein solches elektrisches Netzwerk eine starke Frequenzabhängigkeit aufweisen. Durch die Verwendung des breitbandigen Prüfsignals mit dem Frequenzbereich zwischen 500 kHz und 8 MHz können Fehler in einem weiten Frequenzbereich erfasst werden. Das Messsignal kann entsprechend in einem Messbereich von 500 kHz bis 8 MHz ausgewertet werden. In dem Messbereich von 500 kHz bis 8 MHz kann das Prüfsignal beispielsweise eine Gleichverteilung im Frequenzspektrum aufweisen.

Das Prüfsignal und der ausgewertete Messbereich können auch einen größeren Frequenzbereich umfassen, beispielsweise 16 kHz bis 30 MHz.

Zum Bestimmen der Funktionsfähigkeit der mehreren Mantelspannungsbegrenzer kann gemäß einer Ausführungsform eine Frequenzanalyse von mindestens einem elektrischen Messsignal der mehreren elektrischen Messsignale durchgeführt werden. Vorzugsweise wird für jedes erfasste elektrische Messsignal der mehreren elektrischen Messsignale eine jeweilige Frequenzanalyse durchgeführt. Die Frequenzanalyse kann beispielsweise mittels einer schnellen Fourier-Transformation durchgeführt werden. Die Frequenzanalyse für jedes der mehreren elektrischen Messsignale kann beispielsweise mit einer jeweiligen früheren Referenzmessung verglichen werden. Die früheren Referenzmessungen wurden beispielsweise zu einem Zeitpunkt ermittelt und gespeichert, zu dem sichergestellt war, dass alle involvierten Mantelspannungsbegrenzer in einem ordnungsgemäßen Zustand waren.

Gemäß einer Ausführungsform werden die mehreren Messsignale gleichzeitig erfasst. Das gleichzeitige Erfassen der mehreren Messsignale kann beispielsweise von dem Einspeisen des elektrischen Prüfsignals an dem gemeinsamen Erdungsanschluss ausgelöst werden, sodass die mehreren Messsignale die Reaktion des Hochspannungskabelsystems einschließlich der involvierten Mantelspannungsbegrenzer auf das eingespeiste Messsignal widerspiegeln.

Beispielsweise, können die mehreren Messsignale synchron zu dem Einspeisen des elektrischen Prüfsignals erfasst werden. Das Einspeisen des elektrischen Prüfsignals und das gleichzeitige Erfassen der Messsignale an dem Hochspannungskabelsystem kann beispielsweise synchron mit einer Genauigkeit von 8ns durchgeführt werden.

Gemäß der vorliegenden Erfindung wird weiterhin eine Vorrichtung zum Überprüfen von mindestens einem Mantelspannungsbegrenzer für mindestens ein Hochspannungskabel eines Hochspannungskabelsystems bereitgestellt. Beispielsweise kann die Vorrichtung zum Überprüfen von mehreren Mantelspannungsbegrenzern für mehrere ein Hochspannungskabel eines mehrphasigen Hochspannungskabelsystems ausgestaltet sein. Bei einem einphasigen Hochspannungskabelsystem ist der Mantelspannungsbegrenzer zwischen einen Kabelschirm des Hochspannungskabels und einem Erdungsanschluss geschaltet. Bei einem mehrphasigen Hochspannungskabelsystem ist jeweils ein Mantelspannungsbegrenzer der mehreren Mantelspannungsbegrenzer zwischen einen Kabelschirm eines jeweiligen Hochspannungskabels der mehreren Hochspannungskabel und einen gemeinsamen Erdungsanschluss geschaltet. Die Vorrichtung umfasst eine erste Koppelvorrichtung zum Einspeisen eines elektrischen Prüfsignals an dem gemeinsamen Erdungsanschluss und ein oder mehrere zweite Koppelvorrichtungen zum Erfassen mehrerer elektrischer Messsignale. Ein jeweiliges elektrisches Messsignal der mehreren elektrischen Messsignale wird an dem Kabelschirm eines jeweiligen Hochspannungskabels der mehreren Hochspannungskabel mit einer jeweiligen zweiten Koppelvorrichtung der mehreren zweiten Koppelvorrichtungen erfasst. Die Vorrichtung umfasst ferner eine Verarbeitungsvorrichtung, welche mit der ersten Koppelvorrichtung und den mehreren zweiten Koppelvorrichtungen verbunden ist. Die Verarbeitungsvorrichtung ist ausgestaltet, um das Prüfsignal zu erzeugen und der ersten Koppelvorrichtung zuzuführen. Die Verarbeitungsvorrichtung ist ferner ausgestaltet, um die mehreren elektrischen Messsignale mittels der zweiten Koppelvorrichtung zu erfassen und eine Funktionsfähigkeit der mehreren Mantelspannungsbegrenzer in Abhängigkeit von den mehreren erfassten elektrischen Messsignalen zu bestimmen.

Gemäß einer Ausführungsform umfasst die erste Koppelvorrichtung einen Hochfrequenzstromtransformator. Alternativ oder zusätzlich kann jede der mehreren zweiten Koppelvorrichtungen jeweils einen entsprechenden Hochfrequenzstromtransformator umfassen. Dadurch kann eine kostengünstige induktive Einspeisung des Prüfsignals sowie eine kostengünstige induktive Erfassung der mehreren Messsignale ermöglicht werden.

Die Vorrichtung kann ferner zur Durchführung des zuvor beschriebenen Verfahrens und seiner Ausführungsformen ausgestaltet sein.

### KURZE BESCHREIBUNG DER FIGUREN

Die vorliegende Erfindung wird nachfolgend unter Bezugnahme auf die Zeichnungen anhand bevorzugter Ausführungsformen erläutert werden.
Fig. 1 zeigt schematisch ein Hochspannungskabelsystem mit einer Vorrichtung zum Überprüfen von mehreren Mantelspannungsbegrenzern gemäß einer Ausführungsform der vorliegenden Erfindung.
Fig. 2 zeigt schematisch ein Frequenzspektrum eines Prüfsignals, welches bei einem Verfahren zum Überprüfen von mehreren Mantelspannungsbegrenzern gemäß einer Ausführungsform der vorliegenden Erfindung verwendet wird.
Fig. 3 zeigt schematisch ein Zeitsignal eines Prüfsignals, welches bei einem Verfahren zum Überprüfen von mehreren Mantelspannungsbegrenzern gemäß einer Ausführungsform der vorliegenden Erfindung verwendet wird.
Fig. 4 zeigt Frequenzspektren von phasenbezogenen Messsignalen im Vergleich zu Frequenzspektren von phasenbezogenen Referenzmessungen gemäß einem Verfahren der vorliegenden Erfindung, wobei die Messsignale in einem Hochspannungskabelsystem mit fehlerfreien Mantelspannungsbegrenzern erfasst wurden.
Fig. 5 zeigt Frequenzspektren von phasenbezogenen Messsignalen im Vergleich zu Frequenzspektren von phasenbezogenen Referenzmessungen gemäß einem Verfahren der vorliegenden Erfindung, wobei die Messsignale in einem Hochspannungskabelsystem mit mindestens einem defekten Mantelspannungsbegrenzer, welcher eine Unterbrechung aufweist, erfasst wurden.
Fig. 6 zeigt Frequenzspektren von phasenbezogenen Messsignalen im Vergleich zu Frequenzspektren von phasenbezogenen Referenzmessungen gemäß einem Verfahren der vorliegenden Erfindung, wobei die Messsignale in einem Hochspannungskabelsystem mit mindestens einem defekten Mantelspannungsbegrenzer, welcher einen Kurzschluss aufweist, erfasst wurden.
Fig. 7 zeigt Kreuzkorrelationen von Frequenzspektren von phasenbezogen Messsignalen in Bezug auf Frequenzspektren von phasenbezogenen Referenzmessungen gemäß einem Verfahren der vorliegenden Erfindung, wobei die Messsignale in verschiedenen Zuständen der Mantelspannungsbegrenzer erfasst wurden.
Fig. 8 zeigt Abweichungen von Frequenzspektren von phasenbezogenen Messsignalen in Bezug auf Frequenzspektren von phasenbezogenen Referenzmessungen gemäß einem Verfahren der vorliegenden Erfindung, wobei die Messsignale in verschiedenen Zuständen der Mantelspannungsbegrenzer erfasst wurden.
Fig. 9 zeigt Schritte eines Verfahrens gemäß einer Ausführungsform der vorliegenden Erfindung.

### DETAILLIERTE BESCHREIBUNG VON AUSFÜHRUNGSBEISPIELEN

Nachfolgend werden Ausführungsformen unter Bezugnahme auf die beigefügten Zeichnungen beschrieben werden. Es ist klar, dass die nachfolgende Beschreibung von Ausführungsformen nicht als Beschränkung auszulegen ist. Der Umfang der Erfindung soll nicht durch die hierin beschriebenen Ausführungsformen oder durch die Zeichnungen beschränkt werden. Die Zeichnungen sind lediglich schematische Darstellungen und in den Zeichnungen dargestellte Elemente sind nicht notwendigerweise maßstabsgerecht gezeigt. Verbindungen oder Kopplungen zwischen funktionalen Blöcken, Vorrichtungen, Komponenten oder anderen physikalischen oder funktionalen Einheiten, welche in den Figuren gezeigt sind oder hierin beschrieben werden, können auch durch eine indirekte Verbindung oder Kopplung realisiert werden. Funktionale Blöcke können in Hardware, Firmware, Software oder einer Kombination daraus realisiert werden.

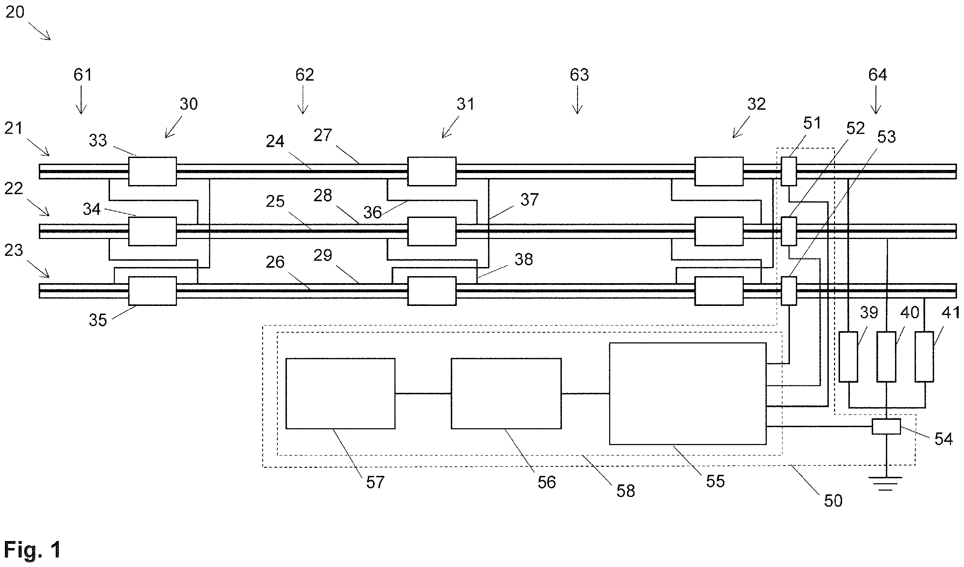

Fig. 1 zeigt schematisch ein Hochspannungskabelsystem 20. Das Hochspannungskabelsystem 20 umfasst drei Hochspannungskabel 21-23, beispielsweise zur Übertragung eines dreiphasigen Wechselstroms. Jedes der drei Hochspannungskabel 21-23 umfasst einen Innenleiter und einen Kabelschirm. Das Hochspannungskabel 21 umfasst den Innenleiter 24 und den Kabelschirm 27, das Hochspannungskabel 22 umfasst den Innenleiter 25 und den Kabelschirm 28 und das Hochspannungskabel 23 umfasst den Innenleiter 26 und den Kabelschirm 29. Jedes der drei Hochspannungskabel 21-23 ist in mehrere Segmente unterteilt. In dem in Fig. 1 gezeigten Beispiel sind die drei Hochspannungskabel 21-23 jeweils in vier Segmente 61-64 unterteilt. Die Anzahl der Segmente hängt von der gewünschten Länge des Hochspannungskabelsystems 20 ab. Typische Segmentlängen liegen im Bereich von 800-1000 m. Bei entsprechenden Längen des Hochspannungskabelsystems 20 können dementsprechend einige zig bis einige 100 Segmente vorgesehen werden.

Diese Segmente 61-64 werden über Verbindungen, sogenannte Joints, miteinander verbunden. In Fig. 1 sind drei Verbindungen 30, 31 und 32 gezeigt. In jeder dieser Verbindungen 30-32 werden die Leiter eines Segments des entsprechenden Hochspannungskabels 21-23 mit dem folgenden Segment des entsprechenden Hochspannungskabels 21-23 verbunden. In der Verbindung 30 wird demzufolge der Innenleiter des Segments 61 des Hochspannungskabels 21 mit dem Innenleiter des Segments 62 des Hochspannungskabels 21 verbunden. Ebenso wird in der Verbindung 30 der Innenleiter des Segments 61 des Hochspannungskabels 22 mit dem Innenleiter des Segments 62 des Hochspannungskabels 22 verbunden und der Innenleiter des Segments 61 des Hochspannungskabels 23 mit dem Innenleiter des Segments 62 des Hochspannungskabels 23 verbunden. Gleiches gilt für die Verbindungen 31 und 32 in Bezug auf die Segmente 62, 63 und 64.

Da in den Kabelschirmen 27-29 durch Induktion und weitere Effekte Potenziale gegenüber Erde entstehen können, werden die Kabelschirme bei den Verbindungen 30-32 jeweils zwischen den drei Phasen ausgekreuzt. Für die Verbindung 31 wird dieses Auskreuzen nachfolgend im Detail beschrieben werden. Der Kabelschirm 27 des Segments 62 des Hochspannungskabels 21 wird über eine Verbindung 36 mit dem Kabelschirm des Segments 63 des Hochspannungskabels 22 verbunden. Der Kabelschirm 28 des Segments 62 des Hochspannungskabels 22 wird über eine Verbindung 38 mit dem Kabelschirm des Segments 63 des Hochspannungskabels 23 verbunden. Schließlich wird der Kabelschirm 29 des Segments 62 des Hochspannungskabels 23 mit dem Kabelschirm des Segments 63 des Hochspannungskabels 21 verbunden. Entsprechende Auskreuzungen werden auch an den Verbindungen 30 und 32 durchgeführt.

Bei einigen der Verbindungen 30-32 werden die Kabelschirme geerdet. Beispielsweise kann bei jeder dritten Verbindung eine entsprechende Erdung vorgesehen sein, beispielsweise bei der Verbindung 32. An diesen Erdungsstellen können große elektrische Ströme auftreten, welche zu begrenzen sind, um beispielsweise thermische Belastungen zu verringern. Dazu werden die Kabelschirme über Mantelspannungsbegrenzer 39-41 (Sheath Voltage Limiter, SVL) mit Erde oder Masse verbunden. Für jeden Kabelschirm eines jeden Hochspannungskabels 21-23 ist ein entsprechender Mantelspannungsbegrenzer 39-41 vorgesehen. Der Mantelspannungsbegrenzer 39 koppelt den Kabelschirm des Hochspannungskabels 21 mit Masse, der Mantelspannungsbegrenzer 40 koppelt den Kabelschirm des Hochspannungskabels 22 mit Masse und der Mantelspannungsbegrenzer 41 koppelt den Kabelschirm des Hochspannungskabels 23 mit Masse.

Durch Spannungsspitzen können die Mantelspannungsbegrenzer 39-41 beschädigt werden. Um die Funktionsfähigkeit der Mantelspannungsbegrenzer 39-41 festzustellen, ist eine Vorrichtung 50 vorgesehen. Die Vorrichtung 50 umfasst mehrere Koppelvorrichtungen 51-54, beispielsweise Hochfrequenzstromtransformatoren (englisch: High Frequency Current Transformer, HFCT). Hochfrequenzstromtransformatoren (HFCT) werden in energietechnischen Systemen beispielsweise verwendet, um Teilentladungen in isolierten Hochspannungskabeln zu überwachen. Diese werden um die Hochspannungskabel gelegt, wodurch elektrische Pulse, die sich in dem Kabelschirm ausbreiten, detektiert werden. Der zugrunde liegende physikalische Effekt, wodurch elektrische Pulse von dem HFCT erkannt werden, kann auch umgekehrt werden und es können kleine elektrische Pulse eingespeist werden. Eine Koppelvorrichtung 54, beispielsweise ein HFCT, ist an einer Leitung vorgesehen, welche die Mantelspannungsbegrenzer 39-41 mit einem gemeinsamen Massepunkt verbindet. Ferner ist an jeder Hochspannungsleitung 21-23 eine entsprechende Koppelvorrichtung 51-53, beispielsweise ein HFCT, vorgesehen.

Die Koppelvorrichtung 54 dient zum Einspeisen eines Prüfsignals in den gemeinsamen Erdungsanschluss der Mantelspannungsbegrenzer 39-41 und die Koppelvorrichtungen 51-53 dienen zum Erfassen von elektrischen Pulsen, welche sich in dem entsprechenden zugeordneten Kabelschirm der Hochspannungskabel 21-23 ausbreiten. Die Koppelvorrichtungen 51-54 sind mit einer Erfassungsvorrichtung 55 verbunden, welche beispielsweise die Signale der Koppelvorrichtungen 51-53 aufnimmt und in entsprechende digitale Messsignale umwandelt. Ferner kann die Erfassungsvorrichtung 55 ausgestaltet sein, digitale Signale in analoge Signale umzuwandeln, welche der Koppelvorrichtung 54 zugeführt werden. Die Erfassungsvorrichtung 55 ist mit einer Steuerung 56 gekoppelt, welche ein Steuersignal erzeugt, welches der Erfassungsvorrichtung 55 zugeführt wird, um aufgrund dieses Steuersignals ein Prüfsignal zu erzeugen, welches der Koppelvorrichtung 54 zum Einspeisen in den gemeinsamen Erdungsanschluss zugeführt wird. Ferner können in der Steuerung 56 die von der Erfassungsvorrichtung 55 bereitgestellten Messsignale aufgenommen, gespeichert und verarbeitet werden. Eine Darstellung der von der Steuerung 56 verarbeiteten Informationen kann mittels eines mit der Steuerung 56 gekoppelten Computers 57 erfolgen. Die zuvor beschriebene grobe Aufteilung von Funktionen auf die Erfassungsvorrichtung 55, die Steuerung 56 und den Computer 57 ist lediglich ein Beispiel und eine beliebige andere Aufteilung ist denkbar. Insbesondere können die Erfassungsvorrichtung 55, die Steuerung 56 und der Computer 57 in einer gemeinsamen Verarbeitungsvorrichtung 58 realisiert werden, welche Hardware, Software und/oder Firmware umfasst, um das nachfolgend beschriebene Verfahren auszuführen.

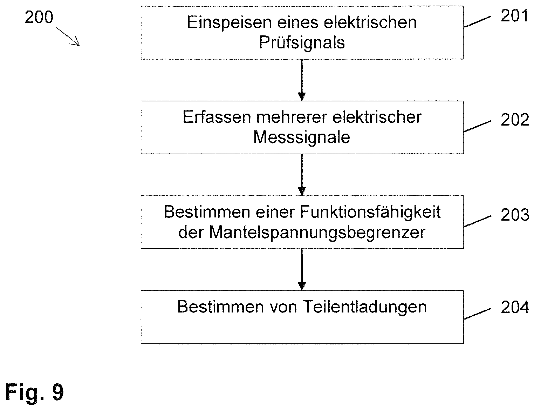

Ein schematischer Überblick des Verfahrens ist in Fig. 9 gezeigt. Das Verfahren 200 umfasst Verfahrensschritte 201-204, wobei der Verfahrensschritt 204 optional ist.

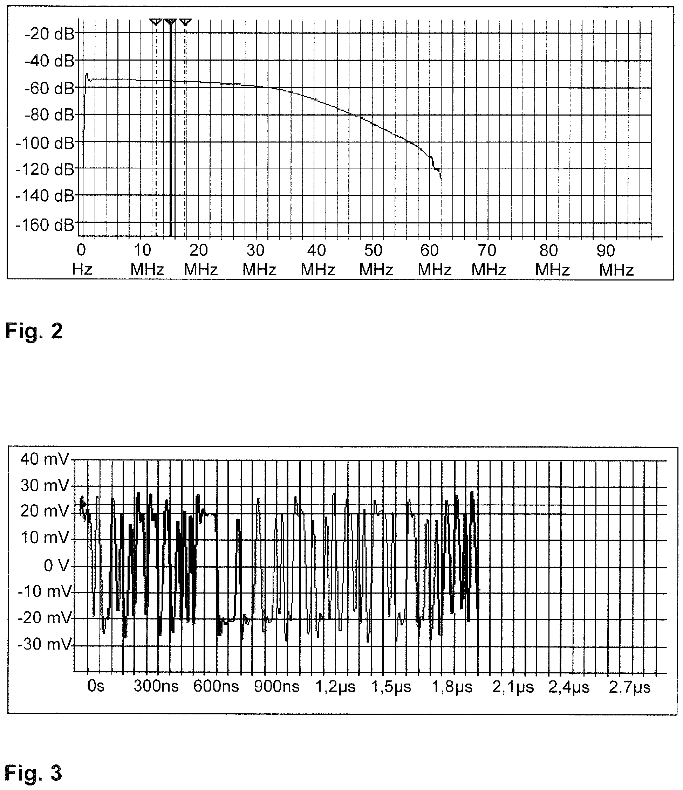

Im Schritt 201 steuert die Verarbeitungsvorrichtung 58 die Koppelvorrichtung 54 derart an, dass ein Prüfsignal in die gemeinsame Erdungsleitung der Mantelspannungsbegrenzer 39-41 eingespeist wird. Durch die induktive Einspeisung kann das Prüfsignal im laufenden Betrieb des Hochspannungskabelsystems 20 erfolgen. Das Prüfsignal weist vorzugsweise einen Frequenzbereich von zumindest 500 kHz bis 8 MHz auf. Fig. 2 zeigt das Frequenzspektrum eines beispielhaften Prüfsignals. Insbesondere in dem Bereich von 500 kHz bis 8 MHz kann das Prüfsignal nahezu eine Gleichverteilung im Frequenzspektrum aufweisen. Fig. 3 zeigt ein entsprechendes Zeitsignal des Prüfsignals der Fig. 2.

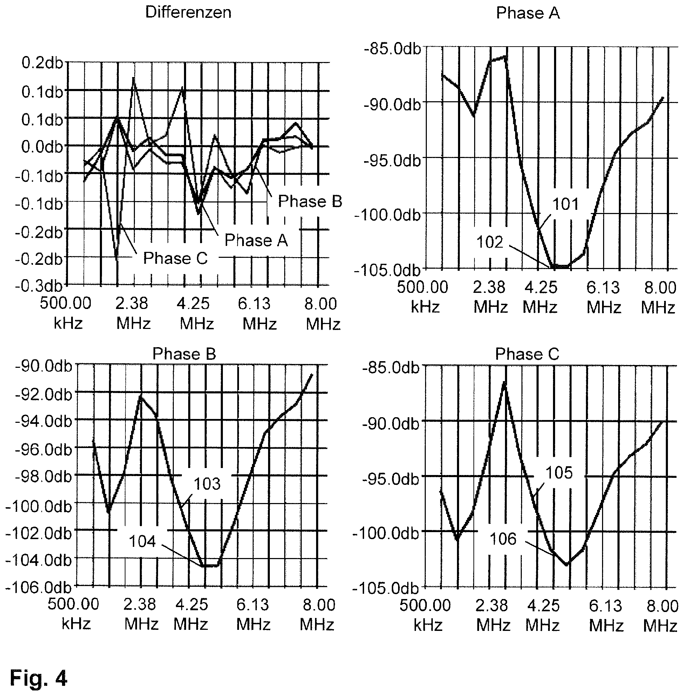

Im Schritt 202 werden im laufenden Betrieb des Hochspannungskabelsystems 20 mittels der Koppelvorrichtungen 51-53 mehrere elektrische Messsignale an den Kabelschirmen der Hochspannungskabel 21-23 erfasst. Die Messsignale können jeweils über einen Zeitraum von bis zu mehreren µs erfasst werden, beispielsweise bis 10 µs. Die Erfassung der mehreren Messsignale erfolgt vorzugsweise gleichzeitig. Für jedes Hochspannungskabel 21-23 wird somit ein elektrisches Messsignal erfasst. Jedes der Hochspannungskabel 21-23 dient der Übertragung einer Phase eines dreiphasigen Wechselstroms. Beispielsweise kann über das Hochspannungskabel 21 eine Phase A des dreiphasigen Wechselstroms, über das Hochspannungskabel 22 eine Phase B des dreiphasigen Wechselstroms und über das Hochspannungskabel 23 eine Phase C des dreiphasigen Wechselstroms übertragen werden. Die an den Hochspannungskabeln 21-23 erfassten elektrischen Messsignale können daher den Phasen A, B und C zugeordnet werden. In den nachfolgenden Figuren 4-8 wird daher Bezug auf die Phasen A, B und C genommen werden, wenn die an den Hochspannungskabeln 21-23 erfassten Messsignale diskutiert werden.

Für die für die Phasen A, B und C erfassten elektrischen Messsignale können jeweils mithilfe einer Frequenzanalyse, beispielsweise einer schnellen Fourier-Transformation, entsprechende Frequenzspektren bestimmt werden. Diese aus den erfassten elektrischen Messsignalen bestimmten Frequenzspektren können mit Referenzfrequenzspektren verglichen werden. Die Referenzfrequenzspektren können beispielsweise zuvor zu einem Zeitpunkt gemessen und ermittelt werden, zu dem sichergestellt ist, dass die Mantelspannungsbegrenzer 39-41 sowie weitere Mantelspannungsbegrenzer in dem Hochspannungskabelsystem 20 in einem ordnungsgemäßen Zustand sind. Die Referenzspektren können beispielsweise in der Verarbeitungsvorrichtung 58 abgespeichert sein.

In Fig. 4 sind entsprechende Referenzspektren 101, 103 und 105 für die Phasen A, B und C gezeigt. Die Referenzspektren 101, 103 und 105 können beispielsweise zuvor mithilfe des Prüfsignals der Figuren 2 und 3 bei der Inbetriebnahme des Hochspannungskabelsystems 20 erfasst und in der Verarbeitungsvorrichtung 58 abgelegt worden sein, beispielsweise in dem Computer 57 oder in der Erfassungsvorrichtung 55. Alternativ können entsprechende Referenzspektren zu einem späteren Zeitpunkt ermittelt werden, beispielsweise auch durch Mittelung mehrerer Messungen, oder mithilfe entsprechender Simulationen berechnet werden.

Eine Referenzmessung zur Bestimmung der Referenzspektren 101, 103 und 105 kann erforderlich sein, da das elektrische Netzwerk bei jeder Messung unterschiedlich ist, unter anderem aufgrund der Längen der Kabel und der physikalischen Eigenschaften von damit verbundenen Systemkomponenten.

Die Frequenzspektren der im laufenden Betrieb erfassten elektrischen Messsignale sind in der Fig. 4 mit den Bezugszeichen 102, 104 und 106 für die Phasen A, B und C gekennzeichnet. In dem Beispiel der Fig. 4 befinden sich die Mantelspannungsbegrenzer 39-41 in einem ordnungsgemäßen Zustand, das heißt, kein Mantelspannungsbegrenzer 39-41 weist einen Kurzschluss oder eine Unterbrechung auf. Daher entsprechen die Spektren 102, 104 und 106 im Wesentlichen den Referenzspektren 101, 103 und 105, sodass in Fig. 4 die Spektren 102, 104 und 106 im Wesentlichen keine Abweichungen zu den entsprechenden Referenzspektren 101, 103, 105 aufweisen und daher kaum sichtbar sind. In dem Diagramm "Differenzen" der Fig. 4 sind die Differenzen zwischen aktuellem Frequenzspektrum und Referenzfrequenzspektrum für die Phasen A, B und C dargestellt, woraus ersichtlich ist, dass die Abweichungen in diesem fehlerfreien Fall tatsächlich äußerst gering sind, im Wesentlichen weniger als 0,2 db.

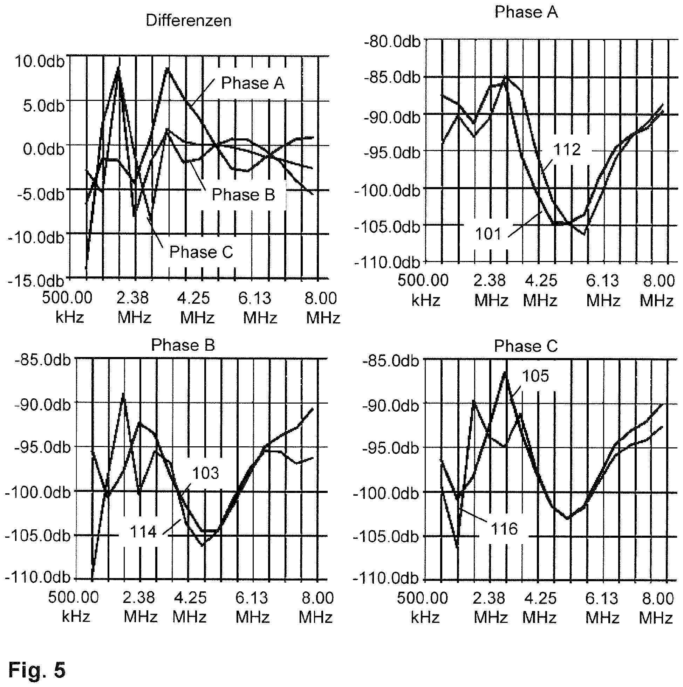

Wenn im laufenden Betrieb des Hochspannungskabelsystems 20 einer oder mehrere Mantelspannungsbegrenzer ausfallen, so ändern sich die Spektren der erfassten elektrischen Messsignale. Fig. 5 zeigt Frequenzspektren 112, 114 und 116 für die Phasen A, B und C, wenn in dem Hochspannungskabelsystem 20 einer der Mantelspannungsbegrenzer 39-41 eine Unterbrechung aufweist und somit nicht mehr funktionsfähig ist. Da über die Auskreuzungen 36-38 in den Verbindungen 30-32 die Kabelschirme miteinander gekoppelt sind, hat diese Unterbrechung von einem der Mantelspannungsbegrenzer 39-41 nicht nur einen Einfluss auf das Messsignal der entsprechenden Phase, sondern auf alle Messsignale der Phasen A, B und C. Wie aus Fig. 5 ersichtlich ist, ergeben sich daher in allen Phasen A, B und C Abweichungen zwischen den Frequenzspektren 112, 114 und 116 der an den Phasen erfassten elektrischen Messsignale und den Referenzfrequenzspektren 101, 103 und 105. In dem Diagramm "Differenzen" der Fig. 5 sind diese Differenzen zwischen aktuellem Frequenzspektrum 112, 114, 116 und den Referenzfrequenzspektren 101, 103 und 105 für die Phasen A, B und C dargestellt. Für alle Phasen ergeben sich erhebliche Abweichungen von bis zu 15 db.

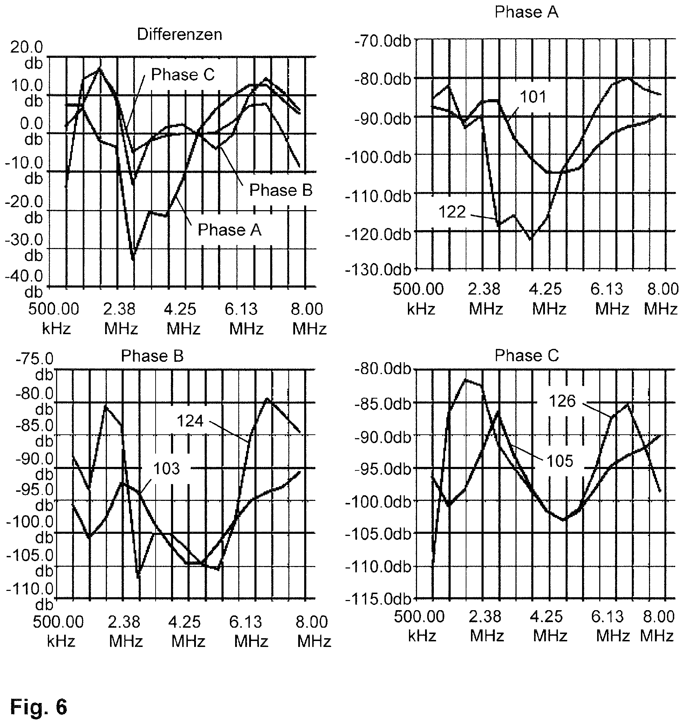

Wenn in dem Hochspannungskabelsystem 20 einer der Mantelspannungsbegrenzer 39-41 einen Kurzschluss aufweist und somit nicht mehr funktionsfähig ist, ändern sich die Frequenzspektren der erfassten elektrischen Messsignale. Fig. 6 zeigt entsprechende Frequenzspektren 122, 124 und 126 für die Phasen A, B und C für diesen Fall. Über die Auskreuzungen 36-38 in den Verbindungen 30-32 ergibt sich ein Einfluss auf alle Messsignale der Phasen A, B und C, selbst wenn nur ein Mantelspannungsbegrenzer an einer der Phasen einen Kurzschluss aufweist. Wie aus Fig. 6 ersichtlich ist, ergeben sich daher an allen Phasen A, B und C Abweichungen zwischen den Frequenzspektren 122, 124 und 126 der an den Phasen erfassten elektrischen Messsignale und den Referenzfrequenzspektren 101, 103 und 105. In dem Diagramm "Differenzen" der Fig. 6 sind diese Differenzen zwischen aktuellem Frequenzspektrum 122, 124, 126 und den Referenzfrequenzspektren 101, 103 und 105 für die Phasen A, B und C dargestellt. Auf allen Phasen zeigen sich erhebliche Abweichungen von bis zu 35 db.

Im Schritt 203 (Fig. 9) kann auf der Grundlage der erfassten elektrischen Messsignale die Funktionsfähigkeit der Mantelspannungsbegrenzer 39-41 bestimmt werden. Beispielsweise kann auf der Grundlage von Vergleichen zwischen den Frequenzspektren der erfassten elektrischen Messsignale und der Referenzfrequenzspektren die Funktionsfähigkeit der Mantelspannungsbegrenzer 39-41 bestimmt werden. Beispielsweise können für jede Phase A, B und C jeweils Kreuzkorrelationen zwischen dem Frequenzspektrum der erfassten elektrischen Messsignale und dem Referenzfrequenzspektrum bestimmt werden. Wenn die Frequenzspektren der erfassten elektrischen Messsignale mit den Referenzfrequenzspektren korrelieren, sind die Mantelspannungsbegrenzer 39-41 funktionsfähig. Bei fehlerhaften Mantelspannungsbegrenzern 39-41 sinkt der Wert der Kreuzkorrelation.

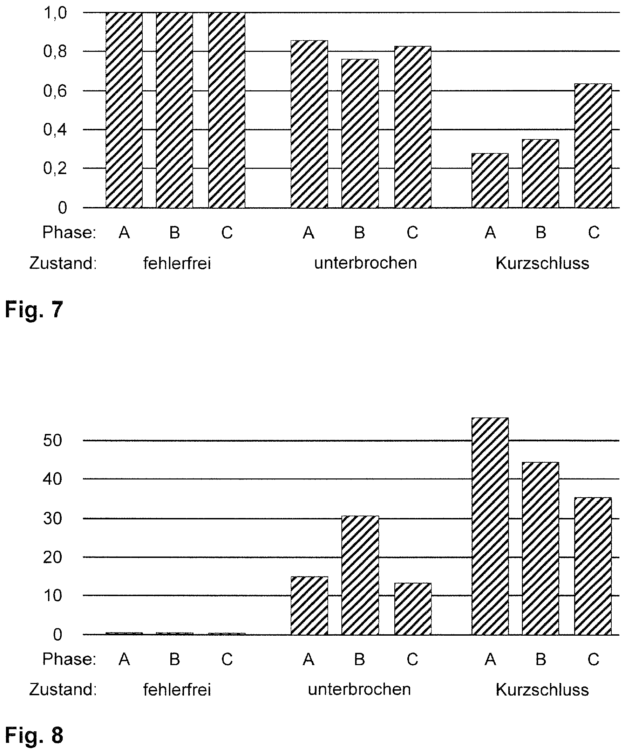

Fig. 7 zeigt beispielhaft Kreuzkorrelationen für die drei Phasen A, B und C für die in den Figuren 4-6 dargestellten Fälle, den fehlerfreien Fall der Fig. 4, den Fall eines unterbrochenen Mantelspannungsbegrenzers der Fig. 5 und den Fall eines Mantelspannungsbegrenzers mit Kurzschluss der Fig. 6. Im fehlerfreien Fall beträgt der Korrelationswert für jede der Phasen A, B und C jeweils näherungsweise eins. In den Fehlerfällen der Figuren 5 und 6 (unterbrochener Mantelspannungsbegrenzer beziehungsweise Mantelspannungsbegrenzer mit Kurzschluss) ist der Korrelationswert hingegen deutlich geringer als eins, beispielsweise im Bereich von 0,8 für den Fall des unterbrochenen Mantelspannungsbegrenzers und im Bereich von 0,3-0,6 für den Fall des Mantelspannungsbegrenzers mit Kurzschluss.

Die Verarbeitungsvorrichtung 58 kann beispielsweise die Korrelationswerte für die Phasen A, B und C bestimmen und mit einem Schwellenwert vergleichen, beispielsweise mit einem Schwellenwert von 0,9, und einen fehlerfreien Zustand der Mantelspannungsbegrenzer 39-41 anzeigen, wenn die Korrelationswerte jeweils über dem Schwellenwert liegen, und anderenfalls einen Fehler anzeigen.

Alternativ oder zusätzlich zu der Kreuzkorrelation kann im Schritt 203 die Funktionsfähigkeit der Mantelspannungsbegrenzer 39-41 auf der Grundlage von Abweichungen bestimmt werden. Beispielsweise kann für jede Phase A, B und C jeweils eine Abweichung zwischen dem Frequenzspektrum der erfassten elektrischen Messsignale und dem Referenzspektrum bestimmt werden. Bei geringen Abweichungen sind die Mantelspannungsbegrenzer 39-41 funktionsfähig. Fig. 8 zeigt beispielhaft Abweichungen für die drei Phasen A, B und C für die in den Figuren 4-6 dargestellten Fälle, den fehlerfreien Fall der Fig. 4, den Fall eines unterbrochenen Mantelspannungsbegrenzers der Fig. 5 und den Fall eines Mantelspannungsbegrenzers mit Kurzschluss der Fig. 6. Im fehlerfreien Fall beträgt die Abweichung für jede der Phasen A, B und C jeweils näherungsweise null. In den Fehlerfällen der Figuren 5 und 6 ist die Abweichung deutlich über null, beispielsweise im Bereich von 10-35 für den Fall des unterbrochenen Mantelspannungsbegrenzers und im Bereich von 30-60 für den Fall des Mantelspannungsbegrenzers mit Kurzschluss.

Die Verarbeitungsvorrichtung 58 kann beispielsweise die Abweichungen für die Phasen A, B und C bestimmen und mit einem Schwellenwert vergleichen, beispielsweise mit einem Schwellenwert von fünf. Ein fehlerfreier Zustand der Mantelspannungsbegrenzer 39-41 wird angezeigt, wenn die Abweichungen jeweils unter dem Schwellenwert liegen. Anderenfalls wird ein Fehlerzustand für die Mantelspannungsbegrenzer 39-41 ausgegeben.

Auf der Grundlage der Ausgabe von der Verarbeitungsvorrichtung 58 kann im Fehlerfall eine genauere Fehlersuche eingeleitet werden, beispielsweise durch Abschalten des Kabelsystems 20 und Ausbau und Überprüfung der involvierten Mantelspannungsbegrenzer 39-41. Der fehlerfreie Fall kann hingegen im Betrieb des Hochspannungskabelsystems festgestellt werden. Darüber hinaus ist eine kontinuierliche oder wiederholte Durchführung der zuvor beschriebenen Schritte 201-203 möglich, sodass das Hochspannungskabelsystem kontinuierlich auf defekte Mantelspannungsbegrenzer hin untersucht werden kann.

Im optionalen Schritt 204 können die erfassten Messsignale zusätzlich ausgewertet werden, um Teilentladungen in der Isolation zwischen dem Innenleiter und dem Kabelschirm der Hochspannungskabel 21-23 zu detektieren. Auch diese Detektion kann kontinuierlich oder wiederholt im laufenden Betrieb des Hochspannungskabelsystems 20 durchgeführt werden.

## Patentansprüche

1. Verfahren zum Überprüfen von mindestens einem Mantelspannungsbegrenzer für mindestens ein Hochspannungskabel eines Hochspannungskabelsystems, wobei ein jeweiliger Mantelspannungsbegrenzer des mindestens einen Mantelspannungsbegrenzers (39-41) zwischen einen Kabelschirm (27-29) eines jeweiligen Hochspannungskabels des mindestens einen Hochspannungskabels (21-23) und einen Erdungsanschluss geschaltet ist, wobei das Verfahren umfasst:
- Einspeisen (201) eines elektrischen Prüfsignals an dem Erdungsanschluss,
- Erfassen (202) von mindestens einem elektrischen Messsignal,
wobei ein jeweiliges elektrisches Messsignal des mindestens einen elektrischen Messsignals an dem Kabelschirm (27-29) eines jeweiligen Hochspannungskabels des mindestens einen Hochspannungskabels (21-23) erfasst wird, und
- Bestimmen (203) einer Funktionsfähigkeit des mindestens einen Mantelspannungsbegrenzers (39-41) in Abhängigkeit von dem mindestens einen erfassten elektrischen Messsignal.

2. Verfahren nach Anspruch 1,
wobei das Einspeisen des elektrischen Prüfsignals und das Erfassen des mindestens einen elektrischen Messsignals im Betrieb des Hochspannungskabelsystems (20) durchgeführt wird.

3. Verfahren nach Anspruch 2, ferner umfassend:
- Bestimmen (204) von Teilentladungen zwischen einem Innenleiter (24-26) und einem Kabelschirm (27-28) von dem mindestens einen Hochspannungskabel (21-23) in Abhängigkeit von dem erfassten mindestens einen Messsignal.

4. Verfahren nach einem der vorhergehenden Ansprüche,
wobei das Prüfsignal ein breitbandiges Prüfsignal mit einem Frequenzbereich von zumindest 500 kHz bis 8 MHz umfasst.

5. Verfahren nach einem der vorhergehenden Ansprüche,
wobei das Bestimmen (203) der Funktionsfähigkeit des mindestens einen Mantelspannungsbegrenzers (39-41) eine Frequenzanalyse von dem mindestens einen elektrischen Messsignal umfasst.

6. Verfahren nach Anspruch 5,
wobei die Frequenzanalyse eine schnelle Fourier-Transformation umfasst.

7. Verfahren nach einem der vorhergehenden Ansprüche,
wobei das Bestimmen (203) der Funktionsfähigkeit des mindestens einen Mantelspannungsbegrenzers (39-41) ein Vergleichen des erfassten mindestens einen elektrischen Messsignals mit mindestens einem elektrischen Messsignal einer vorhergehenden Referenzmessung umfasst.

8. Verfahren nach einem der vorhergehenden Ansprüche,
wobei das elektrische Prüfsignal induktiv eingespeist wird.

9. Verfahren nach einem der vorhergehenden Ansprüche,
wobei das mindestens eine elektrische Messsignal induktiv erfasst wird.

10. Verfahren nach einem der vorhergehenden Ansprüche,
wobei der mindestens eine Mantelspannungsbegrenzer mehrere Mantelspannungsbegrenzer umfasst,
wobei das Hochspannungskabelsystem ein mehrphasiges Hochspannungskabelsystem umfasst,
wobei das mindestens eine Hochspannungskabel mehrere Hochspannungskabel des mehrphasigen Hochspannungskabelsystems umfasst,
wobei der jeweilige Mantelspannungsbegrenzer der mehreren Mantelspannungsbegrenzer (39-41) zwischen den Kabelschirm (27-29) des jeweiligen Hochspannungskabels der mehreren Hochspannungskabel (21-23) und den gemeinsamen Erdungsanschluss geschaltet ist,
wobei das Einspeisen (201) des elektrischen Prüfsignals ein Einspeisen (201) des elektrischen Prüfsignals an dem gemeinsamen Erdungsanschluss umfasst,
wobei das Erfassen (202) von mindestens einem elektrischen Messsignal ein Erfassen (202) mehrerer elektrischer Messsignale umfasst, wobei ein jeweiliges elektrisches Messsignal der mehreren elektrischen Messsignale an dem Kabelschirm (27-29) eines jeweiligen Hochspannungskabels der mehreren Hochspannungskabel (21-23) erfasst wird, und
wobei das Bestimmen (203) der Funktionsfähigkeit des mindestens einen Mantelspannungsbegrenzers (39-41) ein Bestimmen (203) der Funktionsfähigkeit der mehreren Mantelspannungsbegrenzer (39-41) in Abhängigkeit von den mehreren erfassten elektrischen Messsignalen umfasst.

11. Verfahren nach Anspruch 10,
wobei die mehreren Messsignale gleichzeitig erfasst werden.

12. Verfahren nach einem der vorhergehenden Ansprüche,
wobei das mindestens eine Messsignal synchron zu dem Einspeisen des elektrischen Prüfsignals erfasst wird.

13. Vorrichtung zum Überprüfen von mindestens einem Mantelspannungsbegrenzer für mindestens ein Hochspannungskabel eines Hochspannungskabelsystems, wobei ein jeweiliger Mantelspannungsbegrenzer des mindestens einen Mantelspannungsbegrenzers (39-41) zwischen einen Kabelschirm (27-29) eines jeweiligen Hochspannungskabels des mindestens einen Hochspannungskabels (21-23) und einen Erdungsanschluss geschaltet ist, wobei die Vorrichtung (50) umfasst:
- eine erste Koppelvorrichtung (54) zum Einspeisen eines elektrischen Prüfsignals an dem Erdungsanschluss,
- mindestens eine zweite Koppelvorrichtung (51-53) zum Erfassen von mindestens einem elektrischen Messsignal, wobei eine jeweilige zweite Koppelvorrichtung der mindestens einen zweiten Koppelvorrichtung (51-53) derart ausgestaltet ist, dass sie ein jeweiliges elektrisches Messsignal des mindestens einen elektrischen Messsignals an dem Kabelschirm (27-29) eines jeweiligen Hochspannungskabels des mindestens einen Hochspannungskabels (21-23) erfasst, und
- eine Verarbeitungsvorrichtung (58), welche mit der ersten Koppelvorrichtung (54) und der mindestens einen zweiten Koppelvorrichtung (51-53) verbunden ist und ausgestaltet ist, um:
das Prüfsignal zu erzeugen und der ersten Koppelvorrichtung (54) zuzuführen, das mindestens eine elektrische Messsignal mittels der mindestens einen zweiten Koppelvorrichtung (51-53) zu erfassen, und
eine Funktionsfähigkeit des mindestens einen Mantelspannungsbegrenzers (39-41) in Abhängigkeit von dem mindestens einen erfassten elektrischen Messsignal zu bestimmen.

14. Vorrichtung nach Anspruch 13,
wobei die erste Koppelvorrichtung (54) und die mindestens eine zweite Koppelvorrichtung (51-53) jeweils einen Hochfrequenzstromtransformator umfassen.

15. Vorrichtung nach Anspruch 13 oder Anspruch 14,
wobei die Vorrichtung (50) zur automatischen Durchführung des Verfahrens (200) nach einem der Ansprüche 1-12 ausgestaltet ist.

## Claims

1. A method for testing at least one sheath voltage limiter for at least one high-voltage cable of a high-voltage cable system, wherein a respective sheath voltage limiter of the at least one sheath voltage limiter (39-41) is connected between a cable shield (27-29) of a respective high-voltage cable of the at least one high-voltage cable (21-23) and a ground terminal, the method comprising:
- injecting (201) an electrical test signal at the ground terminal,
- detecting (202) at least one electrical measurement signal,
wherein a respective electrical measurement signal of the at least one electrical measurement signal is detected at the cable shield (27-29) of a respective high-voltage cable of the at least one high-voltage cable (21-23), and
- determining (203) a functional capability of the at least one sheath voltage limiter (39-41) depending on the at least one detected electrical measurement signal.

2. The method according to claim 1,
wherein injecting the electrical test signal and detecting the at least one electrical measurement signal is performed during operation of the high-voltage cable system (20).

3. The method according to claim 2, further comprising:
- determining (204) partial discharges between an inner conductor (24-26) and a cable shield (27-28) of the at least one high-voltage cable (21-23) depending on the detected at least one measurement signal.

4. The method according to any one of the preceding claims,
wherein the test signal comprises a broadband test signal having a frequency range of at least 500 kHz to 8 MHz.

5. The method according to any one of the preceding claims,
wherein determining (203) the functional capability of the at least one sheath voltage limiter (39-41) comprises a frequency analysis of the at least one electrical measurement signal.

6. The method according to claim 5,
wherein the frequency analysis comprises a Fast Fourier Transform.

7. The method according to any one of the preceding claims,
wherein determining (203) the functional capability of the at least one sheath voltage limiter (39-41) comprises comparing the detected at least one electrical measurement signal with at least one electrical measurement signal of a previous reference measurement.

8. The method according to any one of the preceding claims,
wherein the electrical test signal is inductively injected.

9. The method according to any one of the preceding claims,
wherein the at least one electrical measurement signal is inductively detected.

10. The method according to any one of the preceding claims,
wherein the at least one sheath voltage limiter comprises a plurality of sheath voltage limiters,
wherein the high-voltage cable system comprises a multiphase high-voltage cable system,
wherein the at least one high-voltage cable comprises a plurality of high-voltage cables of the multiphase high-voltage cable system,
wherein the respective sheath voltage limiter of the plurality of sheath voltage limiters (39-41) is connected between the cable shield (27-29) of the respective high-voltage cable of the plurality of high-voltage cables (21-23) and the common ground terminal,
wherein injecting (201) the electrical test signal comprises injecting (201) the electrical test signal at the common ground terminal,
wherein the detecting (202) of at least one electrical measurement signal comprises detecting (202) a plurality of electrical measurement signals, wherein a respective electrical measurement signal of the plurality of electrical measurement signals is detected at the cable shield (27-29) of a respective high-voltage cable of the plurality of high-voltage cables (21-23), and
wherein determining (203) the functional capability of the at least one sheath voltage limiter (39-41) comprises determining (203) the functional capability of the plurality of sheath voltage limiters (39-41) depending on the plurality of detected electrical measurement signals.

11. The method according to claim 10,
wherein the plurality of measurement signals is detected simultaneously.

12. The method according to any one of the preceding claims,
wherein the at least one measurement signal is detected synchronously with injecting the electrical test signal.

13. A device for testing at least one sheath voltage limiter for at least one high-voltage cable of a high-voltage cable system,
wherein a respective sheath voltage limiter of the at least one sheath voltage limiter (39-41) is connected between a cable shield (27-29) of a respective high-voltage cable of the at least one high-voltage cable (21-23) and a ground terminal, the device (50) comprising:
- a first coupling device (54) for injecting an electrical test signal at the ground terminal,
- at least one second coupling device (51-53) for detecting at least one electrical measurement signal, wherein a respective second coupling device of the at least one second coupling device (51-53) is configured such that it detects a respective electrical measurement signal of the at least one electrical measurement signal at the cable shield (27-29) of a respective high-voltage cable of the at least one high-voltage cable (21-23), and
- a processing device (58) connected to the first coupling device (54) and the at least one second coupling device (51-53) and configured to:
generate the test signal and inject it at the first coupling device (54),
detect the at least one electrical measurement signal by means of the at least one second coupling device (51-53), and
determine a functional capability of the at least one sheath voltage limiter (39-41) depending on the at least one detected electrical measurement signal.

14. The device according to claim 13,
wherein the first coupling device (54) and the at least one second coupling device (51-53) each comprise a high-frequency current transformer.

15. The device according to claim 13 or claim 14,
wherein the apparatus (50) is configured for automatically performing the method (200) according to any one of claims 1-12.

## Revendications

1. Procédé permettant de vérifier au moins un limiteur de tension de gaine pour au moins un câble haute tension d'un système de câbles haute tension, dans lequel un limiteur de tension de gaine respectif de l'au moins un limiteur de tension de gaine (39-41) est monté entre un blindage de câble (27-29) d'un câble haute tension respectif de l'au moins un câble haute tension (21-23) et une borne de mise à la terre, dans lequel le procédé comprend :
- l'injection (201) d'un signal de test électrique au niveau de la borne de mise à la terre,
- la détection (202) d'au moins un signal de mesure électrique,
dans lequel un signal de mesure électrique respectif de l'au moins un signal de mesure électrique est détecté au niveau du blindage de câble (27-29) d'un câble haute tension respectif de l'au moins un câble haute tension (21-23), et
- la détermination (203) d'une capacité de fonctionnement de l'au moins un limiteur de tension de gaine (39-41) en fonction de l'au moins un signal de mesure électrique détecté.

2. Procédé selon la revendication 1,
dans lequel l'injection du signal de test électrique et la détection de l'au moins un signal de mesure électrique sont effectuées pendant le fonctionnement du système de câbles haute tension (20).

3. Procédé selon la revendication 2, comprenant en outre :
- la détermination (204) de décharges partielles entre un conducteur interne (24-26) et un blindage de câble (27-28) de l'au moins un câble haute tension (21-23) en fonction de l'au moins un signal de mesure détecté.

4. Procédé selon l'une des revendications précédentes,
dans lequel le signal de test comprend un signal de test à large bande comportant une gamme de fréquences allant d'au moins 500 kHz à 8 MHz.

5. Procédé selon l'une des revendications précédentes,
dans lequel la détermination (203) de la capacité de fonctionnement de l'au moins un limiteur de tension de gaine (39-41) comprend une analyse de fréquence de l'au moins un signal de mesure électrique.

6. Procédé selon la revendication 5,
dans lequel l'analyse de fréquence comprend une transformation de Fourier rapide.

7. Procédé selon l'une des revendications précédentes,
dans lequel la détermination (203) de la capacité de fonctionnement de l'au moins un limiteur de tension de gaine (39-41) comprend une comparaison de l'au moins un signal de mesure électrique détecté avec au moins un signal de mesure électrique d'une mesure de référence précédente.

8. Procédé selon l'une des revendications précédentes,
dans lequel le signal de test électrique est injecté par induction.

9. Procédé selon l'une des revendications précédentes,
dans lequel l'au moins un signal de mesure électrique est détecté par induction.

10. Procédé selon l'une des revendications précédentes,
dans lequel l'au moins un limiteur de tension de gaine comprend plusieurs limiteurs de tension de gaine,
dans lequel le système de câbles haute tension comprend un système de câbles haute tension polyphasé,
dans lequel l'au moins un câble haute tension comprend plusieurs câbles haute tension du système de câbles haute tension polyphasé,
dans lequel le limiteur de tension de gaine respectif parmi les limiteurs de tension de gaine (39-41) est monté entre le blindage de câble (27-29) du câble haute tension respectif parmi les câbles haute tension (21-23) et la borne de mise à la terre commune,
dans lequel l'injection (201) du signal de test électrique comprend l'injection (201) du signal de test électrique au niveau de la borne de mise à la terre commune,
dans lequel la détection (202) d'au moins un signal de mesure électrique comprend la détection (202) de plusieurs signaux de mesure électriques, dans lequel un signal de mesure électrique respectif parmi les signaux de mesure électriques est détecté au niveau du blindage de câble (27-29) d'un câble haute tension respectif parmi les câbles haute tension (21-23), et
dans lequel la détermination (203) de la capacité de fonctionnement de l'au moins un limiteur de tension de gaine (39-41) comprend la détermination (203) de la capacité de fonctionnement des limiteurs de tension de gaine (39-41) en fonction des signaux de mesure électriques détectés.

11. Procédé selon la revendication 10,
dans lequel les signaux de mesure sont détectés simultanément.

12. Procédé selon l'une des revendications précédentes,
dans lequel l'au moins un signal de mesure est détecté en synchronisme avec l'injection du signal de test électrique.

13. Dispositif permettant de vérifier au moins un limiteur de tension de gaine pour au moins un câble haute tension d'un système de câbles haute tension,
dans lequel un limiteur de tension de gaine respectif de l'au moins un limiteur de tension de gaine (39-41) est monté entre un blindage de câble (27-29) d'un câble haute tension respectif de l'au moins un câble haute tension (21-23) et une borne de mise à la terre, dans lequel le dispositif (50) comprend :
- un premier dispositif de couplage (54) permettant d'injecter un signal de test électrique au niveau de la borne de mise à la terre,
- au moins un second dispositif de couplage (51-53) permettant de détecter au moins un signal de mesure électrique, dans lequel un second dispositif de couplage respectif de l'au moins un second dispositif de couplage (51-53) est configuré de telle sorte qu'il détecte un signal de mesure électrique respectif de l'au moins un signal de mesure électrique au niveau du blindage de câble (27-29) d'un câble haute tension respectif de l'au moins un câble haute tension (21-23), et
- un dispositif de traitement (58) connecté au premier dispositif de couplage (54) et à l'au moins un second dispositif de couplage (51-53) et configuré pour :
générer le signal de test et l'acheminer au premier dispositif de couplage (54), détecter l'au moins un signal de mesure électrique à l'aide de l'au moins un second dispositif de couplage (51-53), et
déterminer une capacité de fonctionnement de l'au moins un limiteur de tension de gaine (39-41) en fonction de l'au moins un signal de mesure électrique détecté.

14. Dispositif selon la revendication 13,
dans lequel le premier dispositif de couplage (54) et l'au moins un second dispositif de couplage (51-53) comprennent respectivement un transformateur de courant haute fréquence.

15. Dispositif selon la revendication 13 ou la revendication 14,
dans lequel le dispositif (50) est configuré pour la mise en oeuvre automatique du procédé (200) selon l'une des revendications 1 à 12.
